Europäisches Patentamt

European Patent Office

Office européen des brevets

(19)

(11) Veröffentlichungsnummer : **0 069 972**
**B1**

(12) **EUROPÄISCHE PATENTSCHRIFT**

(45) Veröffentlichungstag der Patentschrift :
26.06.85

(21) Anmeldenummer : 82106038.1

(22) Anmeldetag : 06.07.82

(51) Int. Cl.⁴ : **G 01 R 29/26, H 04 J 3/14**

(54) **Verfahren und Schaltungsanordnung zur Bestimmung der Signalleistung und der Verzerrungsleistung bei mit Codierung arbeitenden Messobjekten.**

(30) Priorität : 09.07.81 DE 3127176

(43) Veröffentlichungstag der Anmeldung :
19.01.83 Patentblatt 83/03

(45) Bekanntmachung des Hinweises auf die Patenterteilung : 26.06.85 Patentblatt 85/26

(84) Benannte Vertragsstaaten :
FR GB IT

(56) Entgegenhaltungen :
EP-A- 0 030 383
ELECTRONICS AND COMMUNICATIONS IN JAPAN, Band 52-A, Nr. 8, August 1969, Seiten 20-27; KIYOSHI HASHIMOTO et al.: "Speech quality of PCM transmission system". Seite 21, Abschnitt 4, (Equivalent noise); Seite 22 bis Seite 23, Abschnitt 8 (Effect of overload distortion)
TELETEKNIK, Band 18, Nr. 2, 1974, Seiten 72-75, Aarhus (DK); T.K. TAWFIQ: "A digital noise integrating instrument".
FREQUENZ, Band 26, Nr. 5, 1972, Seiten 118-123, H. HESSENMÜLLER et al.: "Rauschklirrmessungen an PCM-Systemen".

(73) Patentinhaber : **Siemens Aktiengesellschaft Berlin und München Wittelsbacherplatz 2 D-8000 München 2 (DE)**

(72) Erfinder : **Schlosser, Karl, Ing. grad. Richard-Wagner-Strasse 12 D-8033 Planegg (DE)**

## Beschreibung

Die Erfindung bezieht sich auf ein Verfahren zur Bestimmung der Signalleistung und der Verzerrungsleistung bei mit codierten Signalen arbeitenden Meßobjekten, insbesondere PCM-Endeinrichtungen, wobei ein sendeseitig erzeugtes erstes Signal über das Meßobjekt der Empfangsseite zugeführt wird und ein zweites unverzerrtes, aus dem ersten Signal abgeleitetes Signal rechnerisch durch Differenzbildung mit diesem verknüpft wird.

Bei einem bekannten Verfahren dieser Art (EP-A1- 00 30 383) wird das Meßobjekt mit einem Meßsignal unterschiedlicher Frequenz beaufschlagt, und es werden auf der Empfangsseite mit umschaltbaren Filtern zeitlich hintereinander verschiedene Frequenzen bzw. Frequenzspektren ausgemessen. Aus den so gewonnenen Meßergebnissen wird über eine Rückübertragung auf die Sendeseite mit einer Auswerteschaltung die Quantisierungsverzerrung durch das Meßobjekt ermittelt. Bei der Auswertung sind hierbei analoge Filterbausteine und Gleichrichter in den Signalweg geschaltet, deren Einschwingvorgänge berücksichtigt werden müssen.

Ein weiteres Meßverfahren zur Bestimmung der Signal- und Verzerrungsleistung ist aus CCITT-Recommendation G712, Band III-2 bekannt. Dabei wird ein erster Sender verwendet, welcher ein Sinussignal mit ca. 1 020 Hz abgibt, dessen Pegel wählbar ist. Die Abtastfrequenz beträgt 8 kHz. Die Frequenz des Sinussignals ist so gewählt, daß sie keine subharmonische der Abtastfrequenz darstellt. Bei einer ersten Messung wird die Signalleistung bestimmt. Bei einer nachfolgenden zweiten Messung wird die empfangsseitige Verzerrungsleistung unter Aussperrung der Signalleistung ermittelt und zwar mittels eines Notch-Filters. Die Bewertung des Meßergebnisses erfolgt psophometrisch.

Bei einer anderen Methode ist ein Sender vorgesehen, welcher ein bandbegrenztes Rauschsignal im Bereich zwischen 350 bis 550 Hz abgibt, wobei die Amplitudenverteilung einer Gauß-Verteilung entspricht. Im einzelnen arbeitet dieser Sender mit einem siebzehnstufigen Schieberegister mit vorgegebener Rückkopplung und einem nachgeschalteten Bandpaß. Das so erzeugte Signal ist ein Linienspektrum mit einem Linienabstand unter 10 Hz.

Auf der Empfangsseite wird über ein Empfangsfilter die Signalleistung bestimmt. Weiterhin ist ein Empfangsfilter vorgesehen, welches die Bestimmung der Verzerrungsleistung gestattet. Diese beiden Messungen können gleichzeitig oder nacheinander durchgeführt werden. Anschließend erfolgt eine Korrektur des Meßergebnisses durch Umrechnung von der Meßbandbreite Bm auf die Bandbreite eines ganzen Fernsprechkanals Bk. Beträgt z. B. die Meßbandbreite Bm = 2 400 Hz und die Kanalbandbreite Bk = 3 100 Hz, so ist der Korrekturfaktor $K = 10 \cdot \log (3 100/2 400) = 1,1$ dB.

Ein Nachteil dieses Verfahrens besteht darin, daß zur Messung der Signalleistung und der Verzerrungsleistung effektiv bewertende Gleichrichterschaltungen notwendig sind, welche eine große Siebzeitkonstante aufweisen müssen. Da die Signalleistung ein Linienspektrum mit Abständen unter 10 Hz ist, entstehen am Ausgang des Gleichrichters Frequenzen unter 10 Hz. Für diese tieffrequentesten Linien muß die Siebzeitkonstante bemessen werden. Die Verzerrungsleistung ist ein stochastisches Signal. Für die Bemessung der Gleichrichterzeitkonstanten gilt folglich die gleiche Überlegung.

Zusätzliche Schwierigkeiten treten dadurch auf, daß die erwähnten Gleichrichterschaltungen formfaktorempfindlich sind, wenn ein größerer Dynamikbereich gefordert wird. Der für eine derartige Meßeinrichtung notwendige Meßumfang von etwa 40 dB ist somit nicht mit einem einzigen Meßbereich realisierbar. Dabei müssen jeweils zusätzliche Wartezeiten für das Abklingen der Einschwingvorgänge hingenommen werden.

Es ist weiterhin bekannt (Kiyoshi Hashimoto et al. : « Speech quality of PCM transmission system », Electronics and Communications in Japan, Band 52-A, Nr. 8, August 1969, Seiten 20-27), bei der Messung von Verzerrungen von Sprachsignalen in elektronischen Übertragungssystemen jeweils eine Messung des unverzerrten und des verzerrten Signals vorzunehmen. Die Messungen werden hier an Modellsystemen und Referenzsystemen durchgeführt, wobei die Bestimmung der Rausch- bzw. Signalanteile rechnerisch im Anschluß an die Messung durchgeführt wird.

Der vorliegenden Erfindung liegt die Aufgabe zugrunde, ein Verfahren der eingangs genannten Art so weiterzubilden, daß die Bestimmung der Verzerrungsleistung schnell und zuverlässig durchgeführt werden kann. Gemäß der Erfindung wird dies bei einem Verfahren der eingangs genannten Art dadurch erreicht, daß das zweite Signal D(t) durch Digitalisierung aus dem ersten Signal S(t) gewonnen wird, wobei das zweite Signal D(t) direkt der auch die rechnerische Auswertung durchführenden Empfangsseite zugeleitet ist, während das erste Signal S(t) über das mindestens eine Codierung und/oder Decodierung durchführende Meßobjekt geführt wird und dabei empfangsseitig das Signal S(t)* ergibt, das gleichzeitig mit dem zweiten Signal der Auswertung zugrunde liegt, daß auf der Empfangsseite der der Signalleistung proportionale Wert

$$Se = \sum_{1}^{n} [Sa(t)]^2$$

gebildet wird, wobei Sa(t) jeweils Abtastproben des durch die Verzerrung des Meßobjektes beeinflußten Signals S(t)* bedeuten und die Zahl n so gewählt ist, daß mindestens das Abtasttheorem erfüllt ist und mindestens eine Periode von S(t)* oder ganzzahlige Vielfache hiervon erfaßt werden, und daß der der Verzerrungsleistung Q proportionale Wert bestimmt wird zu

$$Q = \sum_{1}^{n} [Sa(t) - D(t)]^2 .$$

Die Erfindung geht von dem Gedanken aus, daß bei der Quantisierung eines periodischen Signales S(t) innerhalb eines endlichen Wertebereiches von $\mp$ n-Stufen Fehler entstehen, deren Größe zwischen Null und maximal einem halben Entscheidungsschritt liegen. Das quantisierte Signal S(t)* kann also beschrieben werden als

$$S(t)^* = S(t) \mp 0{,}5 \cdot S(t)/n.$$

Das durch die Quantisierungsverzerrung entstehende Quantisierungsgeräusch Q(t) ist demnach zu definieren als

$$Q(t) = S(t) - S(t)^* = \mp 0{,}5 \cdot S(t)/n.$$

Durch die Erfindung läßt sich das Quantisierungsgeräusch Q(t) somit einfach ermitteln, wenn man vom quantisierten Signal S(t)* das Originalsignal S(t) betrags- und phasenmäßig richtig subtrahiert.

Die Erfindung betrifft weiterhin eine Schaltungsanordnung zur Durchführung des Verfahrens, welche dadurch gekennzeichnet ist, daß auf der Sendeseite zwei Speichereinrichtungen vorgesehen sind, daß die eine Speichereinrichtung ausgangsseitig mit einem Digital-Analogwandler verbunden ist, dessen das Analogsignal S(t) führender Ausgang über das Meßobjekt mit einer empfangsseitig angeordneten Abtast- und Halteschaltung und einem nachfolgenden Analog-Digitalwandler verbunden ist, der mit einem Rechner in Verbindung steht, und daß der Ausgang der zweiten Speichereinrichtung ebenfalls zu dem Rechner geführt ist, welcher die Werte Se und Q bestimmt.

Weiterbildungen der Erfindung sind in den Unteransprüchen wiedergegeben.

Die Erfindung wird nachfolgend an Hand von Zeichnungen näher erläutert. Es zeigen

Figur 1   im Blockschaltbild den Aufbau der gesamten Meßeinrichtung nach der Erfindung
Figur 2   Einzelheiten des Aufbaus des Sendeteils und
Figur 3   Einzelheiten des Aufbaus des Empfangsteiles.

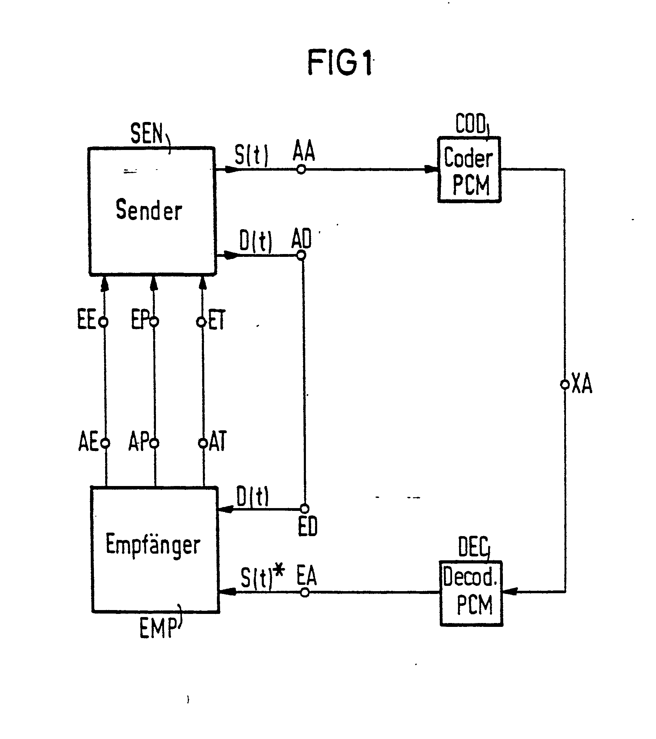

Bei dem Blockschaltbild nach Fig. 1 ist der Sendeteil mit SEN bezeichnet. An einer ersten Ausgangsklemme AA wird ein analoges Sendesignal S(t) abgegeben, während an einer zweiten Ausgangsklemme AD ein Digitalsignal D(t) zur Verfügung steht. Abgesehen von der Tatsache, daß das Signal S(t) in analoger Form und das Signal D(t) in digitaler Form vorliegen, ist angenommen, daß beide Signale inhaltlich übereinstimmen, d. h. das Signal D(t) stellt eine Folge von Augenblickswerten dar, welche aus dem gemeinsamen Grundsignal gewonnen sind. Das analoge Signal S(t) wird einem Coder COD zugeführt, wobei im vorliegenden Beispiel angenommen ist, daß es sich um PCM-Einrichtungen handelt. Dieser Coder COD erzeugt aus dem Analogsignal S(t) ein entsprechend dem gewählten Rahmenaufbau codiertes Signal, das zu einem Decoder DEC gelangt. Da durch den Coder COD und (in geringerem Umfang) durch den Decoder DEC Verzerrungen verursacht werden, ist das an der Eingangsklemme EA beim Empfänger EMP vorhandene Signal S(t)* nicht mehr mit dem ursprünglich vom Sender SEN abgegebenen Signal S(t) identisch. Es gilt vielmehr die Beziehung

$$S(t) = S(t)^* + Q(t).$$

Dabei ist Q(t) der durch den Coder COD und den Decoder DEC verursachte Anteil an Verzerrung.

Um den Anteil Q(t) der Verzerrung bestimmen zu können, erhält der Empfänger EMP auch das dem Signal S(t) korrespondierende digitalisierte Signal D(t). Dieses der Klemme ED des Empfängers EMP zugeführte Signal D(t) ist jedoch nicht über das Meßobjekt, also den Coder COD und dem Decoder DEC gelaufen, sondern wird direkt vom Sender SEN dem Empfänger EMP zugeleitet. Der Empfänger EMP kann in später zu erläuternder Weise daraus die notwendigen Größen ermitteln.

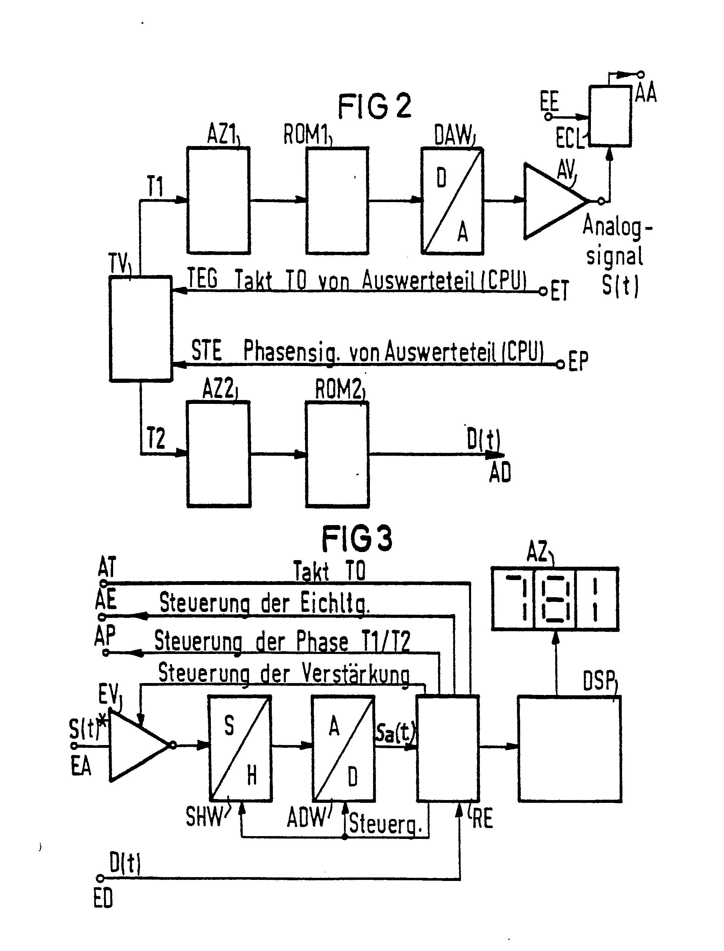

Vom Empfänger EMP aus werden verschiedene Stellgrößen beim Sender SEN beeinflußt. Hierzu sind die Ausgangsklemmen AT, AP und AE vorgesehen, welchen beim Sender SEN die Eingangsklemmen ET, EP und EE entsprechen. An der Klemme AT liegt ein Taktsignal an, welches die Ausgabe der Größen S(t) und D(t) beim Sender SEN steuert. An der Klemme AP liegt ein Steuersignal vor, das die Phasenlage zwischen S(t) und D(t) auf der Sendeseite so beeinflußt, daß diese Signale beim Empfänger EMP, also die Signale D(t) und S(t)* gleichphasig werden. An der Ausgangsklemme AE liegt ein Steuersignal vor welches die Betätigung einer sendeseitig angeordneten Eichleitung bewirkt, damit für den Prüfvorgang unterschiedlich große Pegelwerte von S(t) auf der Sendeseite in den Coder COD eingegeben werden können. Einzelheiten dieser an den Klemmen AE, AP und AT vorliegenden Signale sind im Zusammenhang mit den Figuren 2 und 3 beschrieben.

Bei dem Sendeteil nach Fig. 2 ist ein Taktverteiler TV vorgesehen, der zwei Taktsignale T1 und T2 abgibt. Hierzu wird einem Takteingang TEG des Taktverteilers TV ein Taktsignal TO zugeführt, welches in

3

später noch zu beschreibender Weise vom Rechner RE des Empfangsteiles bereitgestellt und über die Klemme ET zugeführt wird. Der Taktverteiler TV hat einen weiteren Eingang STE, welcher die Phasensteuerung in digitaler Form vom Auswerteteil der Empfangsseite her durchführt und hierzu die Anschlußklemme EP aufweist.

Das Taktsignal T1 gelangt zu einem Adressierzähler AZ1, dessen Ausgang mit einer ersten als Festwertspeicher ausgebildeten Speichereinrichtung ROM1 verbunden ist. Diesem ist ein Digital-Analogwandler DAW nachgeschaltet, dessen Ausgang zu einem Anpassungsverstärker AV geführt ist. Am Ausgang des analogen Anpassungsverstärkers AV liegt somit das Analogsignal S(t) an, welches zum Empfangsteil nach Fig. 3 übertragen wird. Zwischengeschaltet ist noch eine Eichleitung ECL, deren Dämpfungswert zu Beginn der Messung zunächst auf Null eingestellt ist. Ihre Betriebsweise wird später erläutert.

Ein zweiter Ausgang des Taktverteilers TV liefert ein Taktsignal T2 zu einem zweiten Adressierzähler AZ2, dessen Ausgang mit einer zweiten, ebenfalls als Festwertspeicher ausgebildeten Speichereinrichtung ROM2 verbunden ist. Am Ausgang des Festwertspeichers ROM2 liegt an der Klemme AD das Signal D(t) vor. Das Digitalsignal D(t) entspricht inhaltlich dem Signal S(t) lediglich mit dem Unterschied, daß es in digitaler Form, also quantisiert vorliegt. Auch phasenmäßig sind S(t) und D(t) zunächst als gleich vorausgesetzt, d. h. aus ROM1 und ROM2 werden jeweils die gleichen Worte ausgelesen. Der Speicherinhalt von ROM1 und ROM2 stellt ein Prüfprogramm dar. Die Anzahl der in den Festwertspeichern ROM1 und ROM2 gespeicherten Worte und deren Länge wird so bemessen, daß das Abtasttheorem erfüllt ist und die Signale S(t) bzw. D(t), welche sinus- oder rauschförmig sein können, einen ausreichend großen Verzerrungs-Geräuschabstand aufweisen.

Die beiden Festwertspeicher ROM1 und ROM2 können für jede Adresse den gleichen digitalen Inhalt haben. In diesem Fall sind die Taktfrequenzen T1 und T2 gleich gewählt. Dies gibt einen einfacheren Betriebsablauf, ergibt jedoch weniger gute Möglichkeiten für die später noch zu erläuternde Phasennachregelung. Die Takte T1 und T2 können direkt mit dem von der Empfangsseite gelieferten Takt TO übereinstimmen oder ganzzahlige Vielfache (oder Teile) hiervon bilden.

Der Festwertspeicher ROM2 kann auch ein ganzzahliges Vielfaches an Worten gegenüber dem Speicher ROM1 enthalten. In diesem Fall sind die Taktfrequenzen T1 und T2 unterschiedlich zu wählen und zwar so, daß sie zueinander in einem ganzzahligen Verhältnis stehen. Sind z. B. im Festwertspeicher ROM2 k-mal so viele Worte gespeichert, wie im ROM1, dann gilt T2 = k · T1, wobei k ganzzahlig zu wählen ist. Der Vorteil dieser Betriebsweise ist darin zu sehen, daß eine Phasennachregelung (z. B. durch Unterdrücken eines oder mehrerer Takte von T2 im Taktverteiler TV) besonders feinstufig möglich ist. Außerdem stehen die Daten von D(t) mit höherer Abtastrate zur Verfügung, was auf der Empfangsseite günstig ist.

Der Empfangsteil nach Fig. 3 weist für das verzerrte Empfangssignal S(t)* eine Eingangsklemme EA auf, welche zu einem Anpassungsverstärker EV geführt ist, dessen Ausgang an eine Abtast- und Halteschaltung SHW (« sample and hold ») geführt ist. Das Abtastsignal wird einem Analog-Digitalwandler ADW zugeleitet, dessen digitalisiertes Ausgangssignal Sa(t) einem Rechner RE, vorzugsweise einem Mikroprozessor (« CPU »), zugeführt wird. Dieser Rechner RE übernimmt die Signalauswertung und die Ablaufsteuerung, wobei über einen zweiten Eingang das gegenüber S(t)* hinreichend verzerrungsfreie Digitalsignal D(t) dem Rechner RE zugeführt wird. Außerdem führt der Rechner RE die Steuerung der Abtast- und Halteschaltung SHW und des Analog-Digitalwandlers ADW sowie des Verstärkungsfaktors des Verstärkers EV durch. Der Takt, mit dem die Abtast- und Halteschaltung SHW betrieben wird, entspricht dem Takt T2, mit welchem das Auslesen des Digitalsignals D(t) aus dem Festwertspeicher ROM2 erfolgt. Dadurch sind die Signale Sa(t) am Ausgang des Analog-Digitalwandlers ADW und an der Eingangsklemme ED, wo das Digitalsignal D(t) anliegt direkt miteinander vergleichbar und somit leicht im Rechner RE auszuwerten.

Im Rechner RE werden die Werte

$$Se = \sum_{1}^{n} [Sa(t)]^2$$

und

$$Q = \sum_{1}^{n} [Sa(t) - D(t)]^2$$

gebildet, wobei n so gewählt ist, daß wenigstens das Abtasttheorem erfüllt ist und mindestens eine Periode von S(t)* oder ganzzahlige Vielfache hiervon erfaßt werden. Die vom Rechner RE ermittelten Werte, also insbesondere die Quantisierungsverzerrung Q und der Wert der Signalleistung Se sowie gegebenenfalls S(t)*, werden einer digitalen Speichereinrichtung DSP zugeführt, von wo aus die weitere Verarbeitung, z. B. durch Darstellung auf einer Anzeigeeinrichtung AZ, erfolgen kann.

Die Arbeitsvorgänge im Rechner RE sind sehr einfach, weil direkt korrespondierende Abtastwerte von Sa(t) und D(t) für die Berechnung miteinander in Beziehung gesetzt werden können.

Weiterhin können im Rechner RE die Effektivwerte dadurch bestimmt werden, daß aus den Werten Se und Q die Effektivwerte bestimmt werden nach der Beziehung

4

$$Seff = \sqrt{\frac{1}{n} \cdot Se}$$

und

$$Qeff = \sqrt{\frac{1}{n} \cdot Q}.$$

Nachfolgend wird der Meßablauf beschrieben :

Zu Beginn einer Meßreihe besteht u.U. als Folge der Signallaufzeit im Meßobjekt (COD, DEC) bzw. im Sende- und Empfangsverstärker eine Phasenverschiebung zwischen dem aus dem Festwertspeicher ROM2 ausgelesenen Worten D(t) und den mit Hilfe der Abtastschaltung gewonnenen Meßwerten Sa(t). Außerdem können infolge von Grunddämpfungsfehlern die Amplituden zwischen Sa(t) und D(t) auch bei Phasengleichheit voneinander abweichen.

In einem Eichvorgang, bei dem alle Meßwerte Sa(t) über eine Periode (oder ganzzahlige Vielfache hiervon) des (sinus- oder rauschförmigen) Meßsignales ermittelt werden, kann anschließend aus den zeitlichen Lagen (Adressen) des größten Meßwertes und der darauffolgenden Nulldurchgänge bei Sa(t) und D(t) die Amplituden- und Phasendifferenz zwischen beiden Signalen bestimmt und daraus die Korrektur der Phasenlage und der Amplitude vorgenommen werden. Da die Phasenlage von Sa(t) nacheilend ist, wird D(t) durch Unterdrücken einzelner Takte von T2 so lange zeitlich verzögert, bis Phasengleichheit zwischen Sa(t) und D(t) auf der Empfangsseite besteht, d. h. es wird bei D(t) praktisch eine Art « Phasenvorentzerrung » vorgenommen. Je hochfrequenter T2 ist, desto feinstufiger läßt sich der Phasenabgleich durchführen. Die Amplitudendifferenz zwischen Sa(t) und D(t) wird durch ein vom Rechner RE erzeugtes Stellsignal ausgeglichen, das dem Eingangsverstärker EV zugefürt wird und dessen Verstärkung entsprechend anhebt.

Wenn diese zeitlichen und betragsmäßigen Korrelationen erreicht sind, kann eine Meßreihe über eine wählbare Anzahl von Pegelstufen des Sendesignals S(t) erfolgen. Diese Pegelstufen werden vom Rechner RE mittels Steuerbefehlen bei der Eichleitung ECL nacheinander eingestellt, und bei jeder Stufe läuft ein Prüfsignal-Programm durch Auslesen von ROM1 und ROM2 ab.

Für jede Pegelstufe werden über eine oder mehrere Perioden des Meßsignales die Abtastproben Sa(t) und die Differenzen zwischen dem « Sollwert » D(t) und Abtastwert Sa(t) quadratisch addiert.

An Ende des Meßintervalles erhält man :

$$Se = \sum_{n}^{1} [Sa(t)]^2 ,$$

d. h. die Quadratsumme der Abtastproben Sa(t) und als Quadratsumme der Differenzen

$$Q = \sum_{1}^{n} [Sa(t) - D(t)]^2 .$$

Daraus können die Effektivwerte des Nutzsignales Seff, und des Verzerrungssignales Qeff errechnet werden zu

$$Seff = \sqrt{\frac{1}{n} \cdot Se} \qquad Qeff = \sqrt{\frac{1}{n} Q}.$$

Als letzter Arbeitsschritt im Meßzyklus wird das Verhältnis $20 \cdot \log Se/Q$ ermittelt. Da die Signallaufzeit pegelunabhängig ist, muß beim Übergang auf einen anderen Wert des Meßpegels kein neuer Laufzeitausgleich durchgeführt werden. Die erreichbare Genauigkeit läßt sich an einem Beispiel erläutern.

Vorgaben :

Sendesignal : bandbegrenztes Rauschen, bestehend aus einem Linienspektrum im Abstand von 3,906 25 Hz in der Frequenzlage 351, 156 bis 546, 156 Hz. Dieses Signal entsteht durch Auslesen von 2 048 Worten (aus ROM1) zu je 12 Bit mit einem Takt von 8 kHz und Wandlung in einem Digital-Analogumsetzer (DAW).

Signalauswertung empfangsseitig durch Abtastung und Analog-Digitalwandlung (in SHW und ADW) mit der Abtastrate 8 kHz und der Auflösung von 12 Bit.

Die Amplitudenfehler des Sendesignales und der Abtastwerte liegen im Bereich unter 0,1 %. Die Meßunsicherheit ist im wesentlichen aus der Unsicherheit des Phasenausgleichs gegeben. Hierfür ergibt sich für jede Spektrallinie und somit auch für das Gesamtsignal gemäß der allgemein gültigen Additionsformel

$$\sin u - \sin v = 2 \cdot \cos [(u + v)/2] \cdot \sin [(u - v)/2]$$

im konkreten Anwendungsfall

$$\sin (\omega t) - \sin (\omega t \pm \Delta\varphi) = 2 \cdot \cos (\omega t \pm \Delta\varphi) \cdot \sin (\pm \Delta\varphi)$$

ein Anteil im Verhältnis Signalspannung zu Verzerrungsspannung zu

$$\frac{1}{2 \cdot \sin (\pm \Delta\varphi)} \, .$$

Bei der PCM-kodierten Sprachübertragung liegen die Maximalwerte des Verhältnisses S/Q bei etwa 100 zu 1 (entsprechend etwa 40 dB). Die in der relevanten CCITT-Empfehlung geforderte Grenze für die Meßunsicherheit beträgt 5 %. Daraus ergibt sich, daß die aus dem Phasenfehler resultierende « Störspannung » maximal den (1/300)-ten Teil der Signalspannung betragen darf. Anders formuliert muß der Ausdruck

$$\frac{1}{2 \cdot \sin (\pm \Delta\varphi)} \geqq 300$$

sein.

Durch mathematische Umformung erhält man

$$2 \cdot ar (\pm \Delta\varphi) = 0{,}003\,33 \text{ oder } \pm \Delta\varphi = 0{,}1^\circ \, .$$

Bei einer Schwerpunktsfrequenz (= mittlere Linie im Rauschband) von 450 Hz und der daraus resultierenden Periodendauer von 2,222 msec ist also eine Zeitabweichung von 2,222 msec/3 600 = ± 0,6 μsec zulässig, die technisch problemlos erreicht werden kann.

Übliche digitale Schaltkreise arbeiten bis zu Taktfrequenzen von $30 \cdot 10^6$ Hz. Die Abtastung mit einer Auflösung von 12 Bit, entsprechend 1 LSB = 1/4 096, läßt ebenfalls die Phasenkorrektur in der geforderten Größenordnung ohne weiteres zu.

Wenn nur die Verzerrung durch den Decoder DEC gemessen werden soll, wird an der mit XA (fig. 1) bezeichneten Stelle aufgetrennt und dort direkt der Ausgang AA mit dem Analogsignal S(t) angeschlossen. Die Betriebsweise erfolgt so, daß das Auslesen aus dem Lesespeicher ROM1 beim ersten Signal mit einem Rahmenaufbau vorgenommen wird, welcher dem Rahmenaufbau des Meßobjektes entspricht, daß das so gewonnene erste Signal direkt dem Decoder DEC des Meßobjektes zugeführt wird und daß empfangsseitig nach der Decodierung das in analoger Form vorhandene Signal S(t)* durch eine Abtast- und Halteschaltung SHW mit nachfolgendem Analog-Digitalwandler ADW digitalisiert und zur Auswertung bereitgestellt wird.

**Patentansprüche**

1. Verfahren zur Bestimmung der Signalleistung und der Verzerrungsleistung bei mit codierten Signalen arbeitenden Meßobjekten, insbesondere PCM-Endeinrichtungen, wobei ein sendeseitig erzeugtes erstes Signal über das Meßobjekt der Empfangsseite zugeführt wird und ein zweites unverzerrtes, aus dem ersten Signal abgeleitetes Signal rechnerisch durch Differenzbildung mit diesem verknüpft wird, dadurch gekennzeichnet, daß das zweite Signal D(t) durch Digitalisierung aus dem ersten Signal S(t) gewonnen wird, wobei das zweite Signal D(t) direkt der auch die rechnerische Auswertung durchführenden Empfangsseite zugeleitet ist, während das erste Signal S(t) über das mindestens eine Codierung und/oder Decodierung durchführende Meßobjekt geführt wird und dabei empfangsseitig das Signal S(t)* ergibt, das gleichzeitig mit dem zweiten Signal der Auswertung zugrunde liegt, daß auf der Empfangsseite der der Signalleistung proportionale Wert

$$Se = \sum_{1}^{n} [Sa(t)]^2$$

gebildet wird, wobei Sa(t) jeweils Abtastproben des durch die Verzerrung des Meßobjektes beeinflußten Signals S(t)* bedeuten und die Zahl n so gewählt ist, daß mindestens das Abtasttheorem erfüllt ist und mindestens eine Periode von S(t)* oder ganzzahlige Vielfache hiervon erfaßt werden, und daß der der Verzerrungsleistung Q proportionale Wert bestimmt wird zu

$$Q = \sum_{1}^{n} [Sa(t) - D(t)]^2 \, .$$

2. Verfahren nach Anspruch 1, dadurch gekennzeichnet, daß aus den Werten Se und Q die Effektivwerte bestimmt werden nach der Beziehung

$$Seff = \sqrt{\frac{1}{n} \cdot Se}$$

und

$$Qeff = \sqrt{\frac{1}{n} \cdot Q}\,.$$

3. Verfahren nach einem der vorhergehenden Ansprüche, dadurch gekennzeichnet, daß aus den Werten Se und Q das Verhältnis Se/Q ermittelt wird.

4. Verfahren nach einem der vorhergehenden Ansprüche, dadurch gekennzeichnet, daß auf der Empfangsseite eine zwischen dem durch das Meßobjekt beeinflußten ersten Signal S(t)* und dem zweiten, digitalen Signal D(t) bestehende Phasenverschiebung bestimmt und eines dieser Signale in der Phase so weit verändert wird, bis Gleichphasigkeit erreicht ist.

5. Verfahren nach Anspruch 4, bei dem von der Empfangs- zur Sendeseite weitere Signale übertragen werden, dadurch gekennzeichnet, daß von der Empfangsseite zur Sendeseite ein Taktsignal (T0) übertragen wird, welches zur Beseitigung der Phasenverschiebung (Phasenabgleich) benutzt wird, indem für die Erzeugung eines der beiden Signale S(t) und D(t) eine Korrektur in der Taktfolge vorgenommen wird.

6. Verfahren nach Anspruch 5, dadurch gekennzeichnet, daß das erste Signal S(t) und das zweite Signal D(t) durch getaktetes Auslesen aus Lesespeichern (ROM1, ROM2) gebildet werden.

7. Verfahren nach Anspruch 6, dadurch gekennzeichnet, daß das erste Signal S(t) nach dem Auslesen einer Digital-Analogwandlung (in DAW) unterworfen und beim Meßobjekt eine Codierung (in COD) und eine Decodierung (in DEC) vorgenommen wird und daß empfangsseitig nach der Decodierung das in analoger Form vorhandene Signal S(t)* durch eine Abtast- und Halteschaltung (SHW) mit nachfolgendem Analog-Digitalwandler (ADW) digitalisiert und zur Auswertung bereitgestellt wird.

8. Verfahren nach Anspruch 6, dadurch gekennzeichnet, daß das Auslesen aus dem Lesespeicher (ROM1) beim ersten Signal mit einem Rahmenaufbau vorgenommen wird, welcher dem Aufbau des Codierers (COD) des Meßobjektes entspricht, daß das so gewonnene erste Signal direkt dem Decoder (DEC) des Meßobjektes zugeführt wird und daß empfangsseitig nach der Decodierung das in analoger Form vorhandene Signal S(t)* durch eine Abtast- und Halteschaltung (SHW) mit nachfolgendem Analog-Digitalwandler (ADW) digitalisiert und zur Auswertung bereitgestellt wird.

9. Verfahren nach einem der Ansprüche 6 bis 8, dadurch gekennzeichnet, daß die Taktfolge (T2) für das Auslesen des zweiten digitalen Signals D(t) größer gewählt ist als die Taktfolge (T1) beim Auslesen des ersten Signals S(t).

10. Verfahren nach einem der vorhergehenden Ansprüche, dadurch gekennzeichnet, daß auf der Empfangsseite eine zwischen dem durch das Meßobjekt beeinflußten ersten Signal S(t)* und dem zweiten, digitalen Signal D(t) bestehende Amplitudendifferenz bestimmt und ausgeglichen wird.

11. Verfahren nach einem der vorhergehenden Ansprüche mit sendeseitigen Signalen, die einstellbare Pegelwerte aufweisen, dadurch gekennzeichnet, daß für die Erzeugung unterschiedlicher sendeseitiger Ausgangspegel eine Eichleitung (ECL) mit unterschiedlichen Dämpfungswerten eingeschaltet wird, welche das erste Signal S(t) beeinflußt, während das zweite Signal D(t) unverändert zur Empfangsseite geleitet wird, und daß für die Bestimmung der Verzerrungsleistung die Q-Werte entsprechend dem bei der Eichleitung eingestellten Dämpfungswert korrigiert werden.

12. Schaltungsanordnung zur Durchführung des Verfahrens nach einem der vorhergehenden Ansprüche, dadurch gekennzeichnet, daß auf der Sendeseite zwei Speichereinrichtungen (ROM1, ROM2) vorgesehen sind, daß die eine Speichereinrichtung (ROM1) ausgangsseitig mit einem Digital-Analogwandler (DAW) verbunden ist, dessen das Analogsignal S(t) führender Ausgang über das Meßobjekt (COD, DEC) mit einer empfangsseitig angeordneten Abtast- und Halteschaltung (SHW) und einem nachfolgenden Analog-Digitalwandler (ADW) verbunden ist, der mit einem Rechner (RE) in Verbindung steht, daß der Ausgang der zweiten Speichereinrichtung (ROM2) ebenfalls zu dem Rechner (RE) geführt ist, welcher die Werte Se und Q bestimmt.

13. Schaltungsanordnung nach Anspruch 12, dadurch gekennzeichnet, daß der die Phasendifferenz zwischen dem ersten Signal S(t)* und dem zweiten, digitalisierten Signal D(t) bestimmende Rechner (RE) ein Steuersignal erzeugt, welches in einer Taktverteilerschaltung (TV) sendeseitig eine Änderung des Lesetaktes für einen der beiden Lesespeicher (z. B. ROM2) bewirkt und dadurch den Phasenabgleich durchführt.

14. Schaltungsanordnung nach Anspruch 12 oder 13, dadurch gekennzeichnet, daß vor der Abtast- und Halteschaltung (SHW) ein in seiner Verstärkung einstellbarer Verstärker (EV) vorgesehen ist, welcher entsprechend der gemessenen Amplitudendifferenz zwischen S(t)* und D(t) so eingestellt wird, daß Amplitudengleichheit erreicht ist.

15. Verfahren nach einem der Ansprüche 5 bis 11, dadurch gekennzeichnet, daß die Taktfrequenz

7

(T2) für das Auslesen des zweiten, digitalen Signals D(t) gleich der Taktfrequenz für die empfangsseitige Abtast- und Halteschaltung (SWW) gewählt ist.

## Claims

1. A method of determining the signal power and the distortion power in objects to be measured which operate with coded signals, in particular PCM terminal devices, wherein a first signal produced at the transmitting end is fed, via the object to be measured, to the receiving end, and a second undistorted signal derived from the first signal is logic-linked to the latter computationally by difference formation, characterised in that the second signal D(t) is obtained from the first signal S(t) by digitalisation, where the second signal D(t) is directly fed to the receiving end which performs the computational analysis, whereas the first signal S(t) is fed via the object to be measured which performs at least a coding and/or decoding operation and at the receiving end thus produces the signal S(t)* which, together with the second signal, forms the basis of the analysis, that at the receiving end the value

$$Se = \sum_{1}^{n} [Sa(t)]^2$$

which is proportional to the signal power is formed, where Sa(t) signify sample specimens of the signal S(t)* affected by the distortion of the object to be measured, and the number n is selected to be such that at least the sampling theory is fulfilled and at least one period of S(t)* or whole-numbered multiples thereof are covered, and that the value which is proportional to the distortion power Q is specified as

$$Q = \sum_{1}^{n} [Sa(t) - D(t)]^2 .$$

2. A method as claimed in claim 1, characterised in that from the values Se and Q the effective values are specified in accordance with the equation

$$Seff = \sqrt{\frac{1}{n} \cdot Se}$$

and

$$Qeff = \sqrt{\frac{1}{n} \cdot Q} .$$

3. A method as claimed in one of the preceding claims, characterised in that the ratio Se/Q is determined from the values Se and Q.

4. A method as claimed in one of the preceding claims characterised in that at the receiving end a phase shift is determined which exists between the first signal S(t)* which is affected by the object to be measured and the second, digital signal D(t), and one of these signals is changed in phase until phase equality is achieved.

5. A method as claimed in claim 4, wherein further signals are transmitted from the receiving end to the transmitting end, characterised in that from the receiving end to the transmitting end there is transmitted a clock signal (T0) which is used to eliminate the phase shift (phase compensation) in that a correction is carried out in the clock pulse sequence in order to produce one of the two signals S(t) and D(t).

6. A method as claimed in claim 5, characterised in that the first signal S(t) and the second signal D(t) are formed by means of a clock-pulse-controlled read-out from read-out stores (ROM1, ROM2).

7. A method as claimed in claim 6, characterised in that following read-outs the first signal S(t) is subjected to digital-analogue conversion (in DAW), and a coding (in COD) and decoding (in DEC) is carried out in respect of the object to be measured, and that at the receiving end, following decoding, the signal S(t)* which occurs in analogue form is digitalised and made available for analysis by means of a sample- and hold circuit (SHW) followed by an analogue-digital converter (ADW).

8. A method as claimed in claim 6, characterised in that in the case of the first signal the read-out from the read store (ROM1) is carried out with a frame structure which corresponds to the structure of the coder (COD) of the object to be measured, that the first signal obtained in this way is fed directly to the decoder (DEC) of the object to be measured, and that at the receiving end, following decoding, the signal S(t)*, which occurs in analogue form, is digitalised and made available for analysis by means of a sample- and hold circuit (SHW) followed by an analogue-digital converter (ADW).

9. A method as claimed in one of the claims 6 to 8, characterised in that the clock pulse sequence (T2) for the read-out of the second digital signal D(t) is selected to be greater than the clock pulse sequence (T1) for the read-out of the first signal S(t).

10. A method as claimed in one of the preceding claims, characterised in that at the receiving end an amplitude difference, existing between the first signal S(t)* affected by the object to be measured and second, digital signal D(t) is determined and compensated.

11. A method as claimed in one of the preceding claims with transmitting-end signals which exhibit adjustable level values, characterised in that for the production of different transmitting-end output levels, a calibration line (ECL) is connected which has different attenuation values and which influences the first signal S(t), whereas the second signal D(t) is fed unchanged to the receiving end, and that for the determination of the distortion power the Q-values are corrected in accordance with the attenuation value set on the calibration line.

12. A circuit arrangement for the execution of the method claimed in one of the preceding claims, characterised in that at the transmitting end there are arranged two storage devices (ROM1, ROM2), that the first storage device (ROM1) is connected at the output end to a digital-analogue converter (DAW) whose output, which conducts the analogue signal S(t), is connected via the object to be measured (COD, DEC) to a sample- and hold circuit (SHW) arranged at the receiving end and to a following analogue-digital converter (ADW) which is connected to a computer (RE), that the output of the second storage device (ROM2) likewise leads to the computer (RE) which specifies the values Se and Q.

13. A circuit arrangement as claimed in claim 12, characterised in that the computer (RE) which determines the phase difference between the first signal S(t)* and the second, digitalised signal D(t) produces a control signal which, in a clock pulse distributor circuit (TV) at the transmitting end changes the read-out clock pulse train for one of the two read stores (e. g. ROM2) and thereby implements the phase compensation.

14. A circuit arrangement as claimed in claim 12 or 13, characterised in that prior to the sample- and hold circuit (SHW) there is arranged an amplifier (EV) which is adjustable in respect of its amplification and which is set in accordance with the measured amplitude difference between S(t)* and D(t), in such manner that amplitude equality is achieved.

15. A method as claimed in one of the claims 5 to 11, characterised in that the clock pulse frequency (T2) for the read-out of the second, digital signal D(t) is selected to be equal to the clock pulse frequency for the receiving-end sample- and hold circuit (SHW).

**Revendications**

1. Procédé pour déterminer la puissance d'un signal et la puissance de distorsion dans le cas d'objet de mesure travaillant avec des signaux codés, notamment des terminaux MIC, selon lequel un premier signal produit du côté émission est envoyé par l'intermédiaire de l'objet de mesure au côté réception et un second signal sans distorsion, tiré du premier signal est combiné à ce signal par calcul par formation de la différence entre ces signaux, caractérisé par le fait que le second signal D(t) est obtenu par numérisation à partir du premier signal S(t), le second signal D(t) étant envoyé directement au côté réception effectuant également l'évaluation par calcul, tandis que le premier signal S(t) est transmis par l'intermédiaire de l'objet de mesure effectuant au moins un codage et/ou un décodage, et qu'il apparaît alors, du côté réception, le signal S(t)*, qui, en même temps que le second signal, est pris pour base de l'évaluation, que du côté réception, on forme la valeur

$$Se = \sum_{1}^{n} [Sa(t)]^2$$

proportionnelle à la puissance du signal, Sa(t) représentant des échantillons respectifs d'exploration du signal S(t)*, influencés par les distorsions de l'objet de mesure, et le nombre n étant choisi de manière qu'au moins le théorème d'échantillonnage soit satisfait et qu'au moins une période de S(t)* ou un multiple entier de cette période soit détecté, et que la valeur, proportionnelle à la puissance de distorsion Q, est déterminée conformément à

$$Q = \sum_{1}^{n} [Sa(t) - D(t)]^2 .$$

2. Procédé selon la revendication 1, caractérisé en ce que l'on détermine, à partir des valeurs Se et Q, les valeurs efficaces, conformément aux relations

$$Seff = \sqrt{\frac{1}{n} \cdot Se}$$

et

$$Qeff = \sqrt{\frac{1}{n} \cdot Q} .$$

9

3. Procédé suivant l'une des revendications précédentes, caractérisé par le fait qu'à partir des valeurs Se et Q on détermine le rapport Se/Q.

4. Procédé suivant l'une des revendications précédentes, caractérisé par le fait que, du côté réception, on détermine un déphasage existant entre le premier signal S(t)* influencé par l'objet de mesure et le second signal numérique D(t), et qu'on modifie la phase de ces signaux jusqu'à obtenir l'égalité de phase.

5. Procédé suivant la revendication 4, selon lequel des signaux supplémentaires sont transmis du côté réception au côté émission, caractérisé par le fait que du côté réception en direction du côté émission se produit la transmission d'un signal de cadence (T0) qui est utilisé pour éliminer le déphasage (étalonnage de phase), grâce au fait qu'une correction de la suite des impulsions de cadence est réalisée pour la protection de l'un des signaux S(t) et D(t).

6. Procédé suivant la revendication 5, caractérisé par le fait que le premier signal S(t) et le second signal D(t) sont formés au moyen d'une lecture cadencée dans des mémoires mortes (ROM1, ROM2).

7. Procédé suivant la revendication 6, caractérisé par le fait que le premier signal S(t) est soumis, après la lecture, à une conversion numérique/analogique (dans DAW), et qu'un codage (dans COD) et un décodage (dans DEC) sont réalisés dans le cas de l'objet de mesure et que, du côté réception, après le décodage, le signal S(t)* présent sous forme analogique est mis sous forme numérique au moyen d'un circuit d'exploration et de maintien (SHW) en aval duquel est branché un convertisseur analogique/numérique (ADW) et est préparé pour l'évaluation.

8. Procédé suivant la revendication 6, caractérisé par le fait que la lecture dans la mémoire de lecture (ROM1) est réalisée, dans le cas du premier signal, avec une structure de trame qui correspond à la constitution du codeur (COD) de l'objet de mesure, que le premier signal ainsi obtenu est envoyé directement au décodeur (DEC) de l'objet de mesure et que, du côté réception, après le décodage, le signal S(t)* présent sous forme analogique est mis sous forme numérique par un circuit d'exploration et de maintien (SHW) en aval duquel est branché un convertisseur analogique/numérique (ADW), et est préparé pour l'évaluation.

9. Procédé suivant l'une des revendications 6 à 8, caractérisé par le fait que la suite d'impulsions de cadence (T2) pour la lecture du second signal numérique D(t) est choisie supérieure à la suite d'impulsions de cadence (T1) intervenant lors de la lecture du premier signal S(t).

10. Procédé suivant l'une des revendications précédentes caractérisé par le fait que, du côté réception, une différence d'amplitude entre le premier signal S(t)*, influencée par l'objet de mesure, et le second signal numérique D(t), est déterminée et est compensée.

11. Procédé suivant l'une des revendications précédentes, avec du côté émission des signaux possédant des valeurs de niveau réglables, caractérisé par le fait que pour la production de niveaux de sortie différents du côté émission, se trouve branchée une ligne d'étalonnage (ECL) possédant des valeurs d'affaiblissement différentes et qui influe sur le premier signal S(t), tandis que le second signal D(t) est transmis sans modification au côté réception, et que pour la détermination de la puissance de distorsion, les valeurs Q sont corrigées conformément à la valeur d'affaiblissement réglée dans le cas de la ligne d'étalonnage.

12. Montage pour la mise en œuvre du procédé suivant l'une des revendications précédentes caractérisé par le fait qu'il est prévu, du côté émission, deux dispositifs de mémoire (ROM1) et (ROM2), que du côté sortie, l'un des dispositifs de mémoire (ROM1) est relié à un convertisseur numérique/analogique (DAW), dont la sortie délivrant le signal analogique S(t) est reliée, par l'intermédiaire de l'objet de mesure (COD, DEC) à un circuit d'exploration et de maintien (SHW) disposé du côté réception et un convertisseur analogique/numérique (ADW) branché en aval et qui est relié à un calculateur (RE), et que la sortie du second dispositif de mémoire (ROM2) est également raccordée au calculateur (RE) qui détermine les valeurs Se et Q.

13. Montage suivant la revendication 12, caractérisé par le fait que le calculateur (RE), qui détermine la différence de phase entre le premier signal S(t)* et le second signal D(t) mis sous forme numérique, produit un signal de commande qui provoque, dans un circuit distributeur de cadences (TV), du côté émission, une modification de la cadence de lecture pour l'une des deux mémoires mortes (par exemple ROM2) et exécute de ce fait l'étalonnage de phase.

14. Montage suivant la revendication 12 ou 13, caractérisé par le fait qu'en amont du circuit d'exploration et de maintien (SHW), il est prévu un amplificateur (EV) dont l'amplification est réglable et qui est réglé conformément à la différence mesurée d'amplitude entre S(t)* et D(t) de telle sorte que l'on obtient l'égalité des amplitudes.

15. Procédé suivant l'une des revendications 5 à 11, caractérisé par le fait que la fréquence d'horloge (T2) pour la lecture du second signal numérique D(t) est choisie égale à la fréquence d'horloge pour le circuit d'exploration et de maintien (SWW) situé du côté réception.

# FIG 1

# FIG 2

AZ1,     ROM1,     DAW,

EE → | AA

ECL

T1

TV,

AV,

D / A (DAW)

Analogsignal
S(t)

TEG   Takt   T0   von   Auswerteteil (CPU)  ∘ET

STE   Phasensig.   von   Auswerteteil (CPU)  ∘EP

AZ2,     ROM2,

T2

D(t)

AD

# FIG 3

AT             Takt   T0

AZ,

AE    Steuerung der Eichltg.

AP    Steuerung   der   Phase   T1/T2

Steuerung   der   Verstärkung

EV,

DSP,

S(t) *

EA

S / H (SHW)

A / D (ADW)

Sa(t)

SHW,      ADW,  [Steuerg.     RE

D(t)

ED